# EUROPEAN PATENT SPECIFICATION

(11) **EP 0 966 182 B1**
(45) Date of publication and mention of the grant of the patent: **26.04.2006**
(21) Application number: 98306730.7
(22) Date of filing: 21.08.1998
(51) Int. Cl.: H05B 33/10, H01L 27/32

(54) **Method of fabricating organic electroluminescent display panel**
Verfahren zur Herstellung einer organischen Elektrolumineszenzanzeige
Procédé pour la fabrication d'un panneau d'affichage

(30) Priority: 17.06.1998 KR 9822756
(43) Date of publication of application: 22.12.1999
(73) Proprietor: LG ELECTRONICS INC., Seoul (KR)
(72) Inventor: Kim, Chang Nam, Chungnang-gu, Seoul (KR); Kim, Sung Tae, Eungpyung-gu, Seoul (KR); Tak, Yoon Heung, Yongin-si, Kyungki-do (KR)
(74) Representative: McLeish, Nicholas Alistair Maxwell

(56) References cited:
- EP-A- 0 758 192
- WO-A-93/00695
- PATENT ABSTRACTS OF JAPAN vol. 098, no. 004, 31 March 1998 (1998-03-31) & JP 09 320760 A (MATSUSHITA ELECTRIC IND CO LTD), 12 December 1997 (1997-12-12)
- PATENT ABSTRACTS OF JAPAN vol. 096, no. 012, 26 December 1996 (1996-12-26) & JP 08 222371 A (IDEMITSU KOSAN CO LTD), 30 August 1996 (1996-08-30)
- PATENT ABSTRACTS OF JAPAN vol. 017, no. 257 (E-1368), 20 May 1993 (1993-05-20) & JP 05 003077 A (PIONEER ELECTRON CORP), 8 January 1993 (1993-01-08)
- PATENT ABSTRACTS OF JAPAN vol. 017, no. 257 (E-1368), 20 May 1993 (1993-05-20) & JP 05 003076 A (PIONEER ELECTRON CORP), 8 January 1993 (1993-01-08)

## Description

### BACKGROUND OF THE INVENTION

### Field of the Invention

The present invention relates to a novel method of fabricating an organic electroluminescent (hereinafter referred to as EL) display panel comprising organic EL elements which emit light when electric charges are injected into them.

### Discussion of the Background Art

The technology of organic EL devices, also called organic light emitting diodes (LEDs), has been rapidly advancing, and several prototype modules have been successfully demonstrated at exhibitions. Organic EL devices are extremely thin, matrix-addressable and operable at a relatively low voltage, typically less than 15 volts. Furthermore, they have additional features suitable for next generation flat panel displays (FPDs) such as, among other things, little dependence on viewing angle and good device-formability on flexible substrates. A major drawback of liquid crystal display, currently most well-known display of choice, is that most of them require bright backlighting, which can be easily eliminated by the use of an organic EL display.

Organic LEDs differ fundamentally from conventional inorganic LEDs. While the charge transfer in inorganics is band-like in nature and the electron-hole recombination results in the interband emission of light, organic films are generally characterized by the low-mobility activated hopping transport and the emission is excitonic. Organic EL devices are also substantially different from conventional inorganic EL devices, especially in that organic EL devices are operable at low DC voltages.

A substantial amount of research has been directed towards the efficiency improvement and color control of organic LEDs. The efficiency of organic EL devices has now been demonstrated to be certainly adequate for many commercial applications. Moreover, color control is probably not limiting for most potential applications. In light of this, we believe that the outlook for commercial applications is excellent for organic EL devices. The performance of the organic EL devices is quite satisfactory for many applications. It is valuable to think in terms of specific products and manufacturing techniques for the commercialization of organic EL devices. Consideration of the specific applications leads us to believe that more work on manufacturability, uniformity, reliability, and systems issues is required to commercialize organic EL.

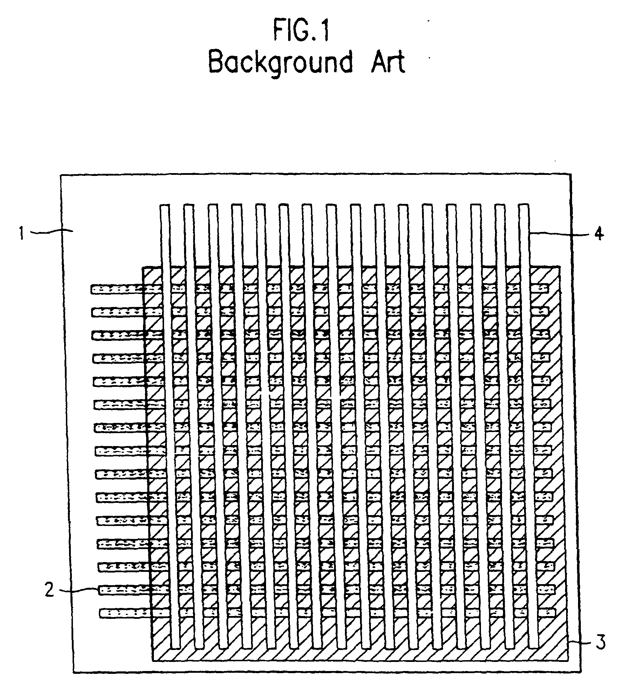

The simplest way to drive an organic EL panel is to have organic function layers sandwiched between two sets of orthogonal electrodes, i.e. rows and columns (Fig. 1). In this passive addressing scheme, the EL element serves both the display and switching functions. The diode-like nonlinear current-voltage characteristic of the organic EL element should, in principle, permit a high degree of multiplexing in this mode of addressing.

Pixelation or patterning, especially of electroluminescent and second electrode materials, is one of the key issues to be resolved before the commercialization of organic EL devices. The use of many conventional pixelation techniques is precluded due to the nature of organic materials which are extremely vulnerable to the attack by most solvents.

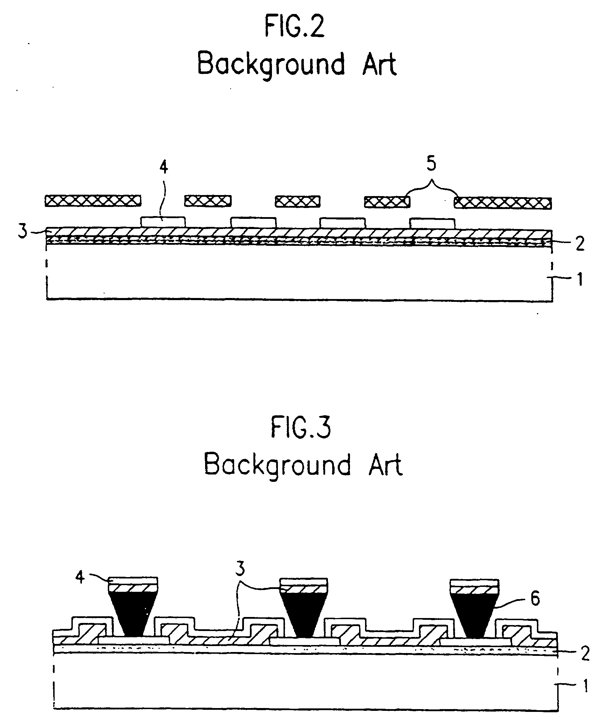

The simplest patterning method is probably to use a shadow mask. As shown in Figs. 1 and 2, the pixelation of organic EL display panel can be accomplished by depositing second electrode material(s) 4 through the openings of a shadow mask 5 onto organic function layers 3 which are, in turn, laminated on a plurality of first electrode stripes 2. Said first electrode stripes 2 are generally formed by patterning a layer of indium tin oxide (ITO) deposited on a transparent, insulating substrate 1.

The pixelation method using a shadow mask becomes less efficient as the display resolution becomes finer. One possible solution for a monochrome display is to separate adjacent pixels using electrically insulating ramparts 6 as suggested in U.S. Patent No. 5,701,055 (Fig. 3).

As disclosed in JP Laid Open Patent No. H8-315981 (Figs. 4a ∼ 4d), the use of additional shadow masks may be required for the construction of a multi or full color display: (1) putting a shadow mask with a plurality of openings (5-1, 5-2 or 5-3) onto top surfaces of the ramparts 6, and aligning each of said openings to be placed over the gap between corresponding ramparts; (2) depositing organic EL medium layers of red (R), green (G) and blue (B) (4-1, 4-2 and 4-3), one by one, through said openings; and (3) forming at least one second electrode layer 3 on said ramparts and said organic function layers

The above method may work fine for a display of moderate resolution and size. As the display size increases and the pitch decreases, however, said method reveals limitations: difficulties in making a shadow mask itself and additionally in aligning said shadow mask with respect to a substrate. The need to make a pixelation without resorting to shadow mask(s) has been, in part, answered by U.S. Patent No. 5,693,962 and JP Laid Open Patent No. H9-293589.

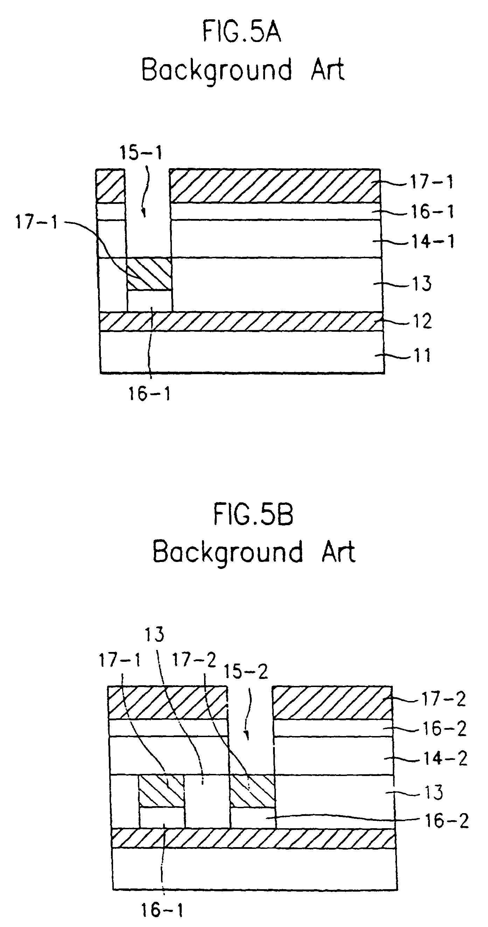

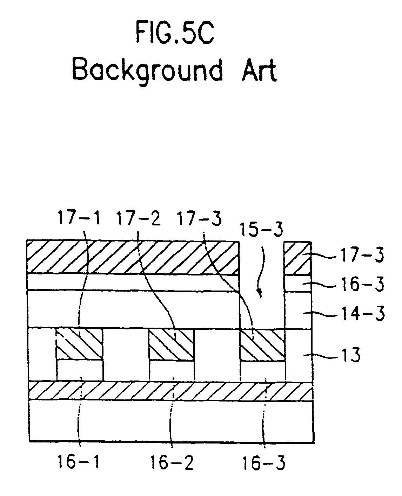

Figs. 5a ∼ 5c illustrate the fabrication steps of a full color panel as suggested in U.S. Patent No. 5,693,962. Fig. 5a describes the formation process of a first sub-pixel: (1) patterning a layer of organic or inorganic conductor deposited on a transparent substrate 11 by conventional lithographic techniques to form a plurality of parallel conductive stripes for the first electrode 12; (2) depositing a layer of dielectric medium 13 on top of said conductive stripes 12 and the exposed portions of substrate 11; (3) spin-coating of a photoresist (PR) layer 14-1 and patterning said dielectric medium 13 by a dry or wet etching technique; (4) laminating an electroluminescent medium 5-1; (5) forming a capping layer 17-1 of the sub-pixel by depositing an air-stable metal on top of said electroluminescent medium: and (6) removing the PR layer 14-1 and those on said PR layer by lift-off. Acetone or a stripping solution is often used for lift-off. It is important to note that said electroluminescent medium can be exposed, through said capping layer, to said solvents during said lift-off process. The device degradation due to said exposure is not surprising, given the relatively poor adhesion between an organic material and a metal used as a capping layer. As shown in Figs. 5b and 5c, second and third sub-pixels can be fabricated by the same token.

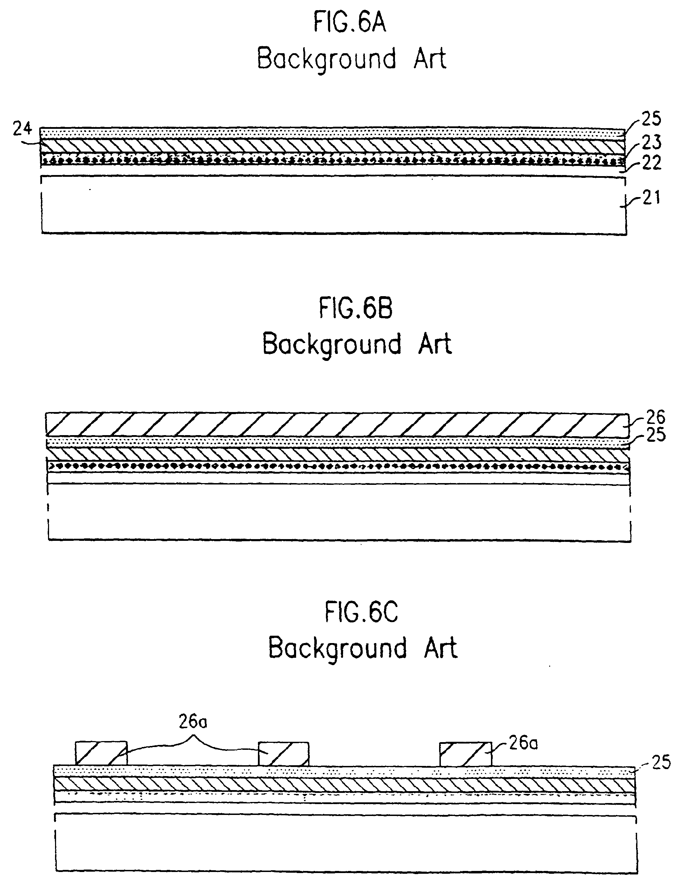

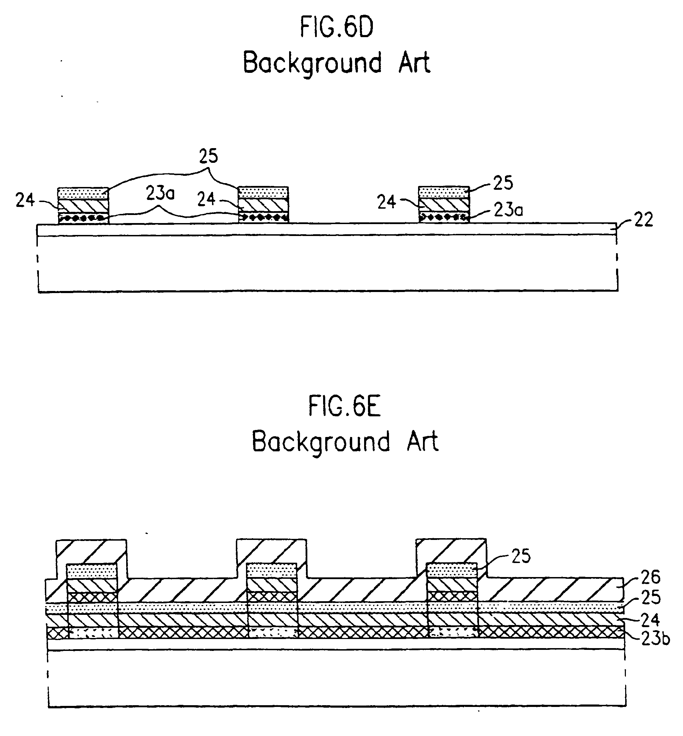

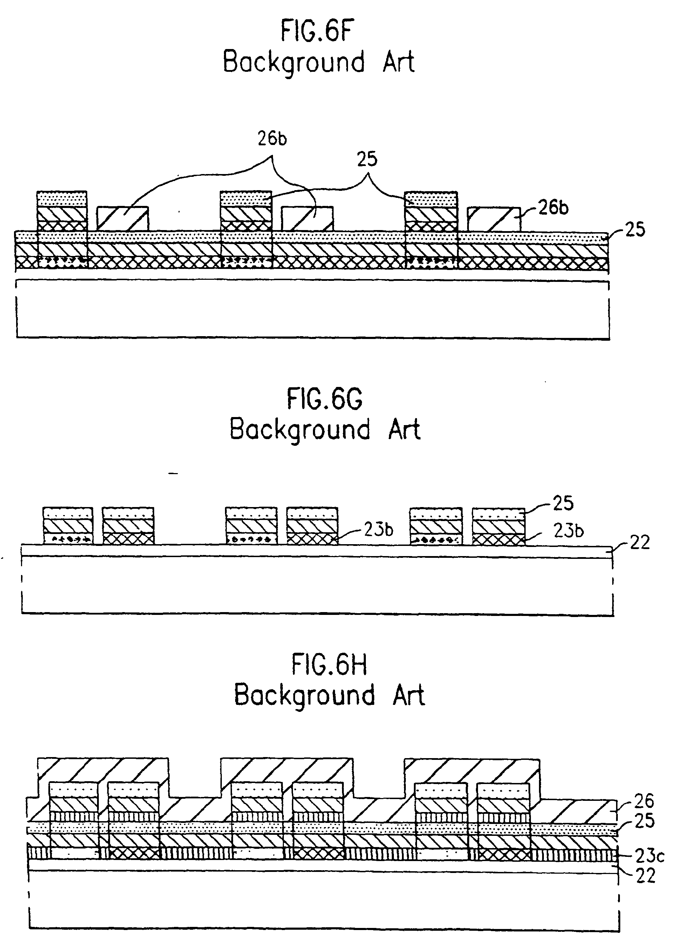

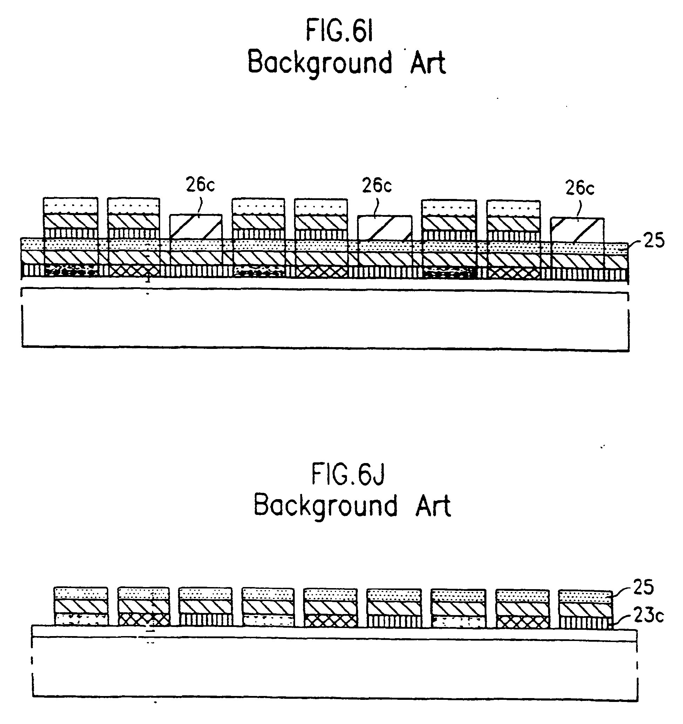

Figs. 6a ∼ 6j describe the processes of forming R, G, B sub-pixels as published in Japanese Laid Open Patent No. H9-293589: (1) forming a first electrode layer 22 on a transparent substrate 21, followed by the lamination of an electroluminescent medium (R) 23, a second electrode 24, and a protection layer 25; (2) spin-casting of photoresist (PR) 26 and subsequent patterning of red sub-pixels; and (3) repeating the above steps to form green and blue sub-pixels. During the above processing steps, active display elements are substantially exposed to PR, which is detrimental to device performance because of solvents remaining in PR. For rough evaluation of adverse effects of photoresist, it is necessary to understand a typical photolithographic process: spin-casting of a photoresist solution on the substrate, soft-baking and exposure to an ultraviolet ray, developing, and hard-baking. In the background art under discussion, the panel is thereafter supposed to be subjected to etching and then PR stripping which again needs stripping solution(s). During spin-casting, active EL elements are already exposed to solvents from the photoresist in a liquid phase.

In short, background methods described above have a serious drawback. Active EL elements are inevitably exposed to various solvents from photoresist or developing and stripping solutions. Said solvents are extremely harmful to electroluminescent medium, and adversely affects the device performance.

EP 0 758 192 A2 discloses a method of fabricating an organic electroluminescent display panel in which a laser protective layer of a heat resistant film is deposited on the anode layer and exposed portions of the transparent substrate. The laser protective layer protects the anode layer when portions of the overlying electroluminescent and cathode layers are removed by laser ablation.

### SUMMARY OF THE INVENTION

Accordingly, the present invention is directed to a novel method of fabricating an organic electroluminescent display panel that addresses one or more of the problems due to limitations and disadvantages of the related art.

An object of the present invention is to provide a method of fabricating an organic EL display panel wherein pixelation can be performed without resorting to the use of a shadow mask and also without active EL elements being exposed to solvents from photoresist or developing and stripping solutions.

Additional features and advantages of the invention will be set forth in the description which follows, and in part will be apparent from the description, or may be learned by practice of the invention. The objectives and other advantages of the invention will be realized and attained by the structure particularly pointed out in the written description and claims hereof as well as the appended drawings.

The invention provides a method of fabricating an organic electroluminescent display panel as set out in claim 1.

In embodiments of the invention, a method of fabricating an organic electroluminescent (EL) display panel having organic function layers including at least one organic EL medium layer laminated between first and second electrodes comprises the step of pixelation by a single or a plurality of laser beams.

Embodiments also comprise the steps of: (1) forming a first electrode layer and an insulating layer in succession on a transparent substrate; (2) removing said insulating layer in the predefined region by a single or.a plurality of laser beams; (3) forming organic function layers and a second electrode layer, in succession, on the predefined surface inclusive of the insulating layer; and (4) repeating the steps of (2) and (3) at least once.

Embodiments also comprise the steps of: (1) forming a first electrode layer and an insulating layer in succession on a transparent substrate; (2) removing said insulating film in the predefined region by a single or a plurality of laser beams; (3) forming organic function layers, a second electrode layer and a protection layer, in succession, on the predefined surface inclusive of the insulating layer; and (4) repeating the steps of (2) and (3) once or more.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide further understanding of the invention and are incorporated in and constitute a part of this specification, illustrate embodiments of the invention and together with the description serve to explain the principles of the invention.

In the drawings:
Fig. 1 illustrates a plan view of a typical passive addressing organic EL display panel;
Fig. 2 is a cross-sectional view showing the process of patterning the second electrode using a shadow mask;

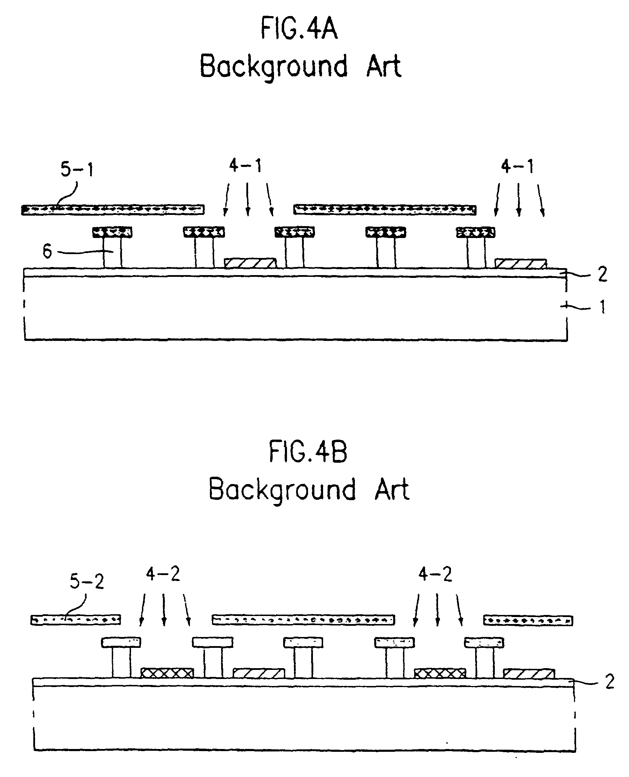

Fig. 3 is a sectional view illustrating the process of pixelation using insulating ramparts;

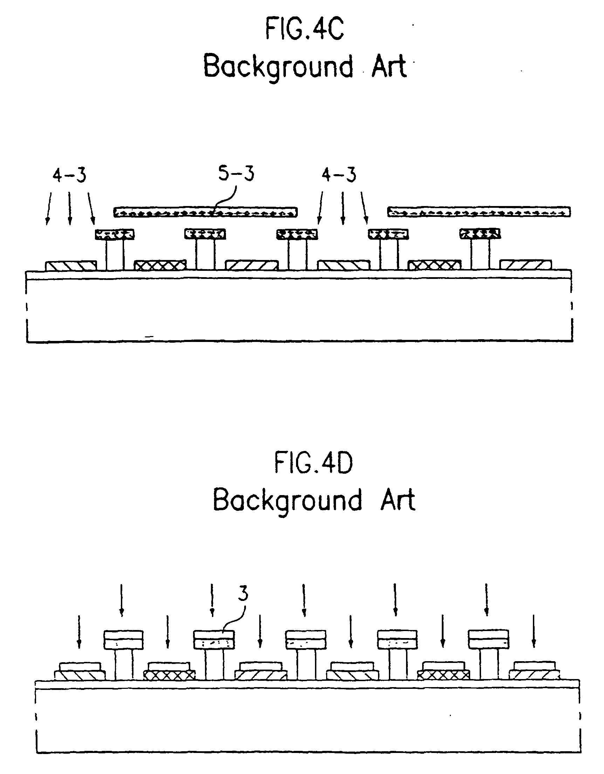

Figs. 4a∼4d, 5a∼5c and 6a∼6j illustrate sectional views showing the fabricating steps of background methods;
Figs. 7a∼7h illustrate sections showing the steps of fabricating an organic EL display panel in accordance with the first embodiment of the present invention;
Figs. 8a∼8k illustrate sections showing the steps of fabricating an organic EL display panel in accordance with the second embodiment of the present invention;
Fig. 9 illustrates an exemplary laser-beam etching system in accordance with an embodiment of the present invention; and,
Fig. 10 illustrates an exemplary process of the laser-beam etching using a mask in accordance with an embodiment of the present invention.

### DETAILED DESCRIPTION OF THE PREFERRED EMBODIMENT

Reference will now be made in detail to the preferred embodiments of the present invention, examples of which are illustrated in the accompanying drawings. For the fabrication of an organic EL display panel with a plurality of emitting portions laminated between a plurality of first and second electrodes, a pixelation method is utilized characterized by employing a laser-beam etching method, by not using a shadow mask for pixelation, and also by preventing active EL elements from being exposed to various solvents from photoresist or developing and stripping solutions. Though the organic EL display panel has a plurality of R(red), G(Green) and B(Blue) sub-pixels, for clarity, only a single set of R, G and B sub-pixels is illustrated in the accompanying drawings.

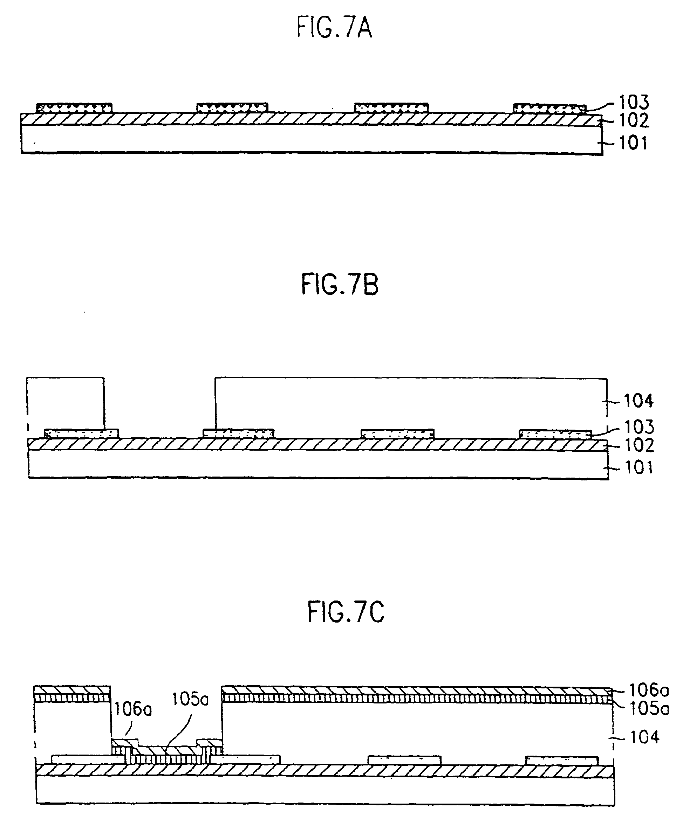

Figs. 7a∼7h illustrate sectional views showing the steps of fabricating an organic EL display panel in accordance with the first embodiment of the present invention. Referring to Fig. 7a, the fabrication processes start with forming the stripes of first electrodes 102 by photolithographically patterning a transparent layer of typically indium tin oxide (ITO) deposited on a transparent substrate 101, and forming the stripes of an electrically insulating buffer layer 103 in orthogonal relationship to said stripes of first electrodes 102. Said buffer layer 103, being not luminescent, serves for the reduction of leakage current by lowering the chance of first electrodes 102 to be microscopically short-circuited to second electrodes that are to be formed in a later step. Said buffer layer 103 can be formed by depositing preferably an inorganic compound such as silicon oxide or silicon nitride or a polymeric material such as polyimide by vapor deposition, e-beam evaporation, RF sputtering, chemical vapor deposition (CVD), spin coating, dipping, Dr. blade method, electro- or electroless plating, or screen printing method.

Then, as shown in Fig. 7b, an insulating layer 104 is formed on the predefined surface inclusive of said buffer layer 103, and a laser-beam etching is performed to remove a portion of said insulating layer 104 wherein red emitting sub-pixels are to be formed in the next step. The material for said insulating layer 104 needs to have a considerable absorption cross-section at the wavelength of the laser beam used and additionally a good film-forming characteristic. Said material is preferably polymeric, for example photoresist, and is preferably formed to a thickness of 0.1 ∼ 100µm.

The most distinctive difference between the background art and the embodiment lies in the fact that (1) the process involving a photoresist is performed before the lamination of any electroluminescent medium, and (2) therefore, the photoresist used can be hard-baked at a high enough temperature for a long enough time, ensuring complete elimination of any residual solvents inside the PR film. If an EL medium is subjected to that harsh a condition, it will degrade very quickly. Thus, the photoresist used in the background art can not be completely baked. To the contrary, the photoresist used here does not pose any adverse effects onto the device performance.

In the next step, the part of the ITO-coated substrate wherein sub-pixels are to be formed is optionally treated with oxygen plasma or UV/ozone. As shown in Fig. 7c, next, the first organic function layers 105a (for example, red light emitting) and a second electrode layer 106a are deposited, in succession, on the predefined surface inclusive of the insulating film 104. A typical example of organic function layers 105a is: (1) a buffer layer of copper phthalocyanine (CuPc) typically 10nm ~ 20nm thick, (2) a hole transporting layer of N,N'-diphenyl-N,N'-bis(3-methylphenyl)-(1,1'-biphenyl)-4,4'-diamine (TPD) typically 30nm ∼ 50nm thick, and (3) an emitting layer of tris(8-hydroxy-quinolate)aluminum (Alq₃) 40nm ∼ 60nm thick, doped with DCM 2 for the red emission. The second electrode 106a is typically formed of any one selected from Al, Ca, Mg:Ag, and Al:Li.

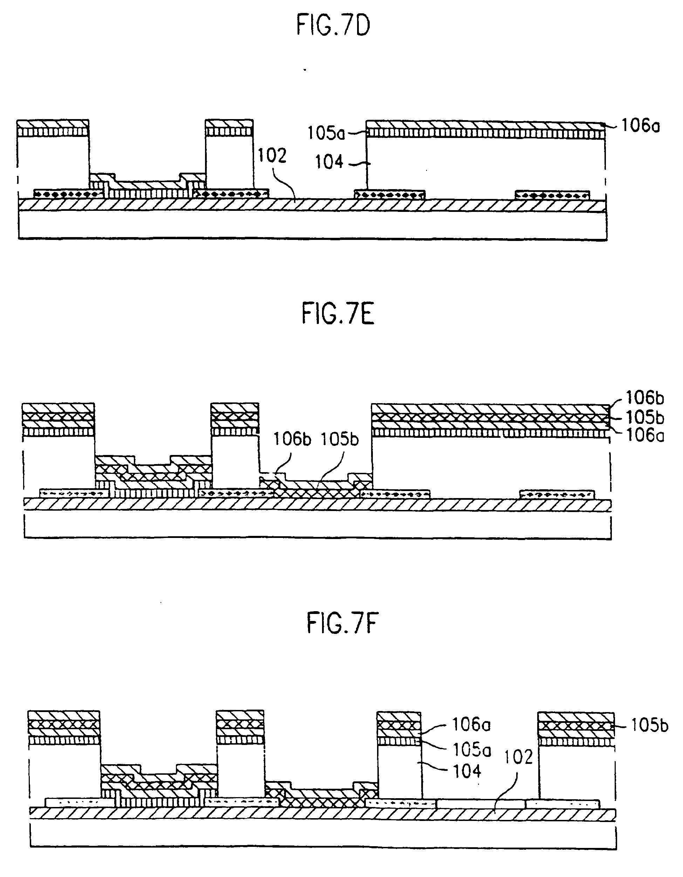

Next (Fig. 7d), another portion of said insulating layer 104 is etched out with a laser beam. Following an optional surface treatment, the second organic function layers 105b (for example, green light emitting) and a third electrode layer 106b are deposited (Fig. 7e). A typical green light emitting EL medium is coumarin 6 doped Alq₃.

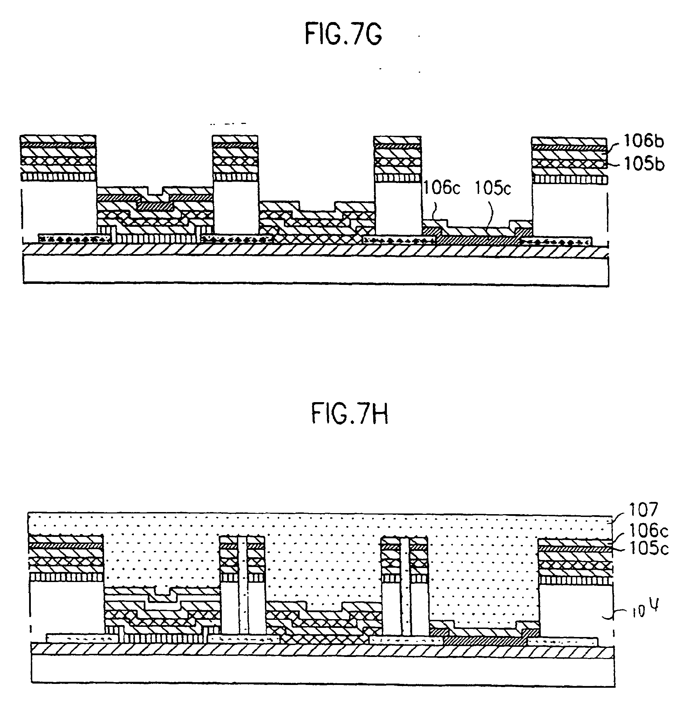

Figs. 7f and 7g illustrate the repetition of a sub-pixel formation for the third color, blue in this instance. BAlq₃ doped with perylene is an example of blue emitting EL medium. To ensure the electrical insulation between two adjacent sub-pixels, it is appropriate to cut into two parts, using a laser-beam, the organic function layers and second electrode layers formed on top of an insulating layer 104 between two adjacent sub-pixels (Fig. 7h). Next, the panel is covered with a protection layer 107 to prevent primarily moisture from penetrating into active EL elements, and is consequently subjected to an encapsulation process. Said protection layer 107 may contain one or a mixture of moisture absorbing ingredients in it. The formation of a protection layer may be performed prior to the laser scribing.

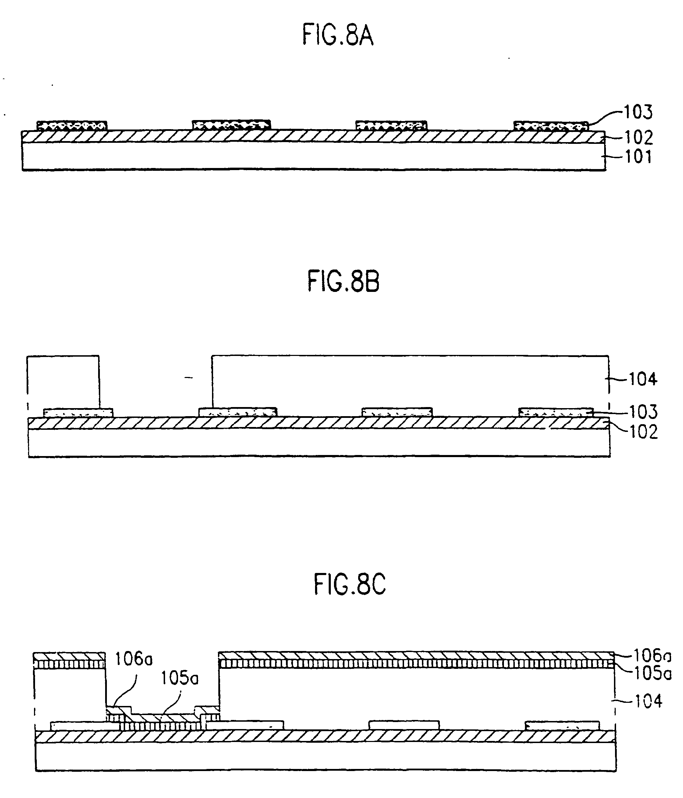

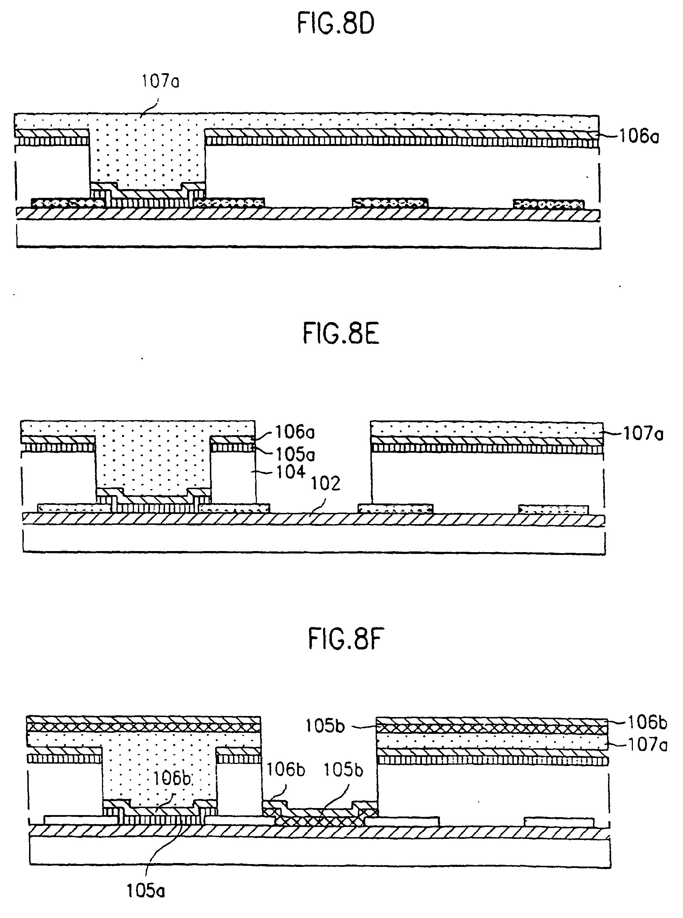

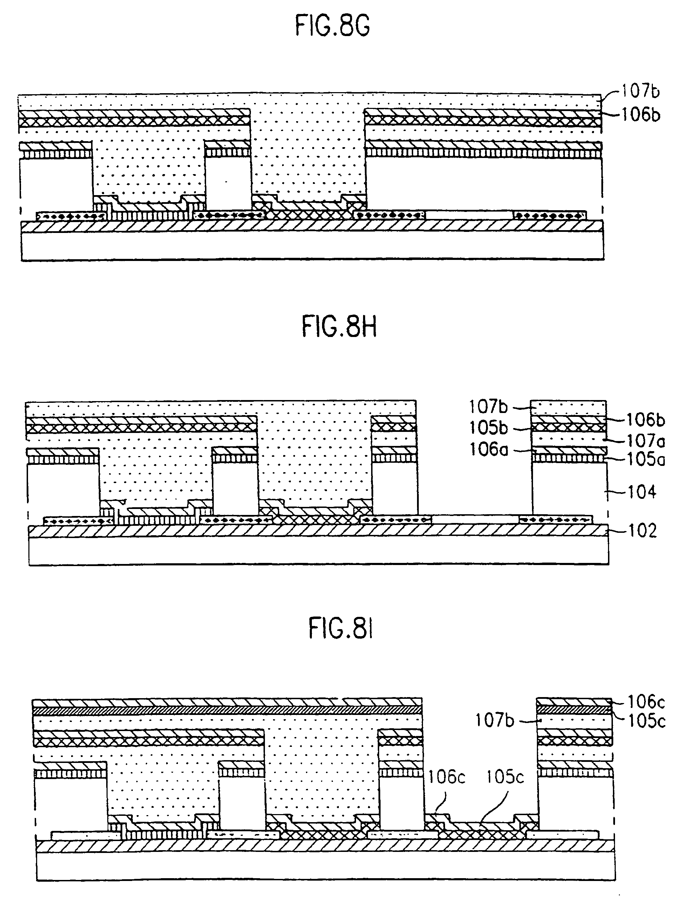

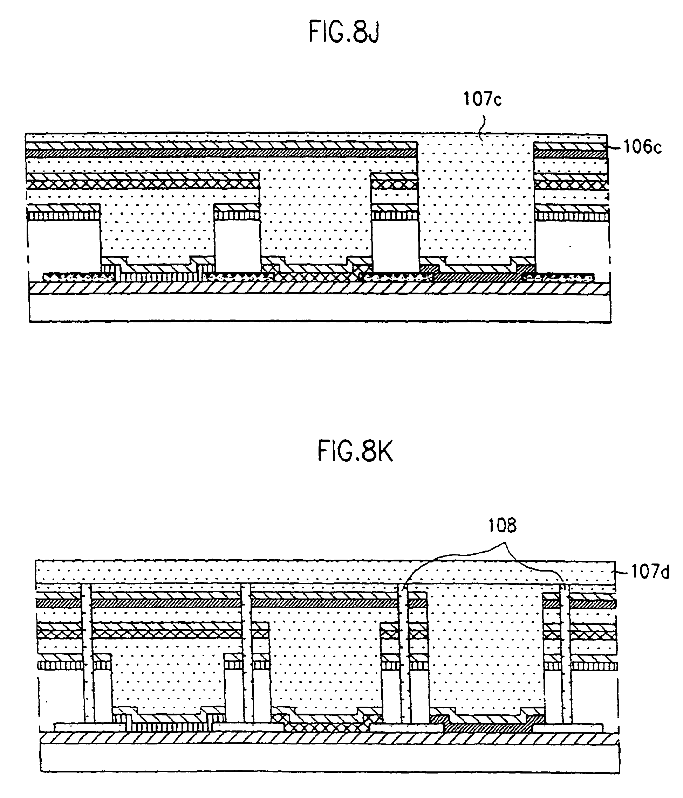

Figs. 8a∼8k illustrate sections showing the steps of fabricating an organic EL display panel in accordance with the second embodiment of the present invention, which is exactly the same as the first embodiment except that a protection film is coated on top of a sub-pixel every time said sub-pixel is formed. The first and second sub-pixels are coated with protection layers 107a and 107b before the formation of the second and third sub-pixels, respectively (Figs. 8d & 8g), and a protection layer 107c is additionally coated after the formation of the third sub-pixel (Fig. 8j). Since said protection layers 107a and 107b can help to shield the first ana second sub-pixels, respectively, from moisture and solvents during the subsequent process steps, the long-term stability should improve and, furthermore, more freedom in the process design can be gained. Said inner protection layers 107a, 107b and 107c remain under the outermost protection layer 107d even after the completion of device fabrication. Therefore, it is highly recommended for said inner protection layers to contain one or a mixture of moisture absorbing ingredients in them.

The beauty of this lies in the simplicity of a sequence of sub-pixel formation steps, i.e the repetition of the laser-beam etching and the formation of EL elements. The details of laser-beam etching techniques and process requirements are as follows.

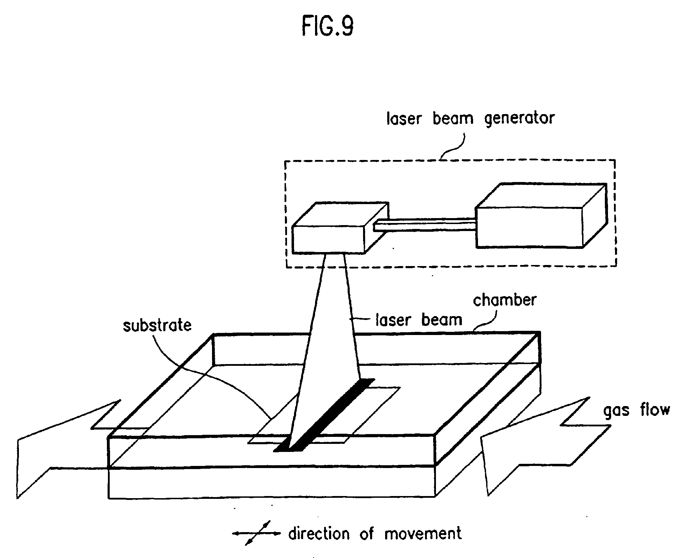

In order to prevent degradation of active display elements during the etching process, the panel under process needs to be located either in vacuum or in a dry or inert atmosphere while the laser beam generator may be operated in the atmosphere. The laser beam is guided into a vacuum chamber or a glove box filled with an inert gas through a window having a limited absorption of the laser beam. Depending on the system design, either the laser beam is scanned (Fig. 9), or the moving stage with a panel mounted on it moves as programmed, generally the former method being less suitable for applications requiring such an accurate position control as in the present invention. Said moving stage may have encoders or sensors attached for a feedback control. It has been found useful that optical and electrical properties of ITO can be used for the feedback control of positioning.

A laser beam with a proper wavelength should be selected considering physical and chemical properties of the materials to be etched, of which the most important factor is the absorption cross-section as a function of wavelength. The lasers much used for etching metals and organic materials are a frequency doubled Nd:YAG laser with a green emission and an excimer laser in ultraviolet. In the present invention, the laser is preferably operated in a pulse mode rather than a continuous mode which may cause a thermal damage to the device. The laser power and pulse repetition rate should be optimized to ablate the second electrode layer and organic function layers, but not to damage the first electrode. A list of lasers usable in the present invention is as follows:

| laser | gas | wavelength (µm) | remark |
|---|---|---|---|
| Nd:YAG | | 1.06 | |
| " | | 0.53 | Frequency Doubled |
| Er:YAG | | 2.9 | |
| Ho:YAG | | 1.9 | |
| Excimer laser | F₂ | 0.16 | |
| " | ArF | 0.19 | |
| " | KrF | 0.25 | |
| " | XeCl | 0.31 | |
| " | XeF | 0.35 | |
| Ar ion laser | Ar | 0.52 | |
| N₂ laser | N₂ | 0.34 | |

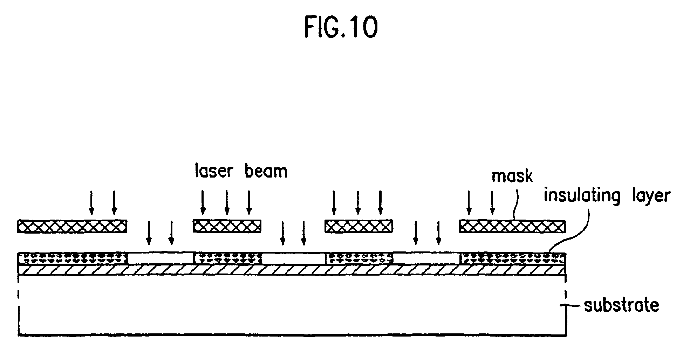

Depending on the process design, the laser beam may be directed into the panel from the first electrode side or from the second electrode side. ITO, a typical first electrode material, apparently does not have a large absorption cross-section at 0.53 µm, and thus a frequency doubled Nd:YAG laser may be irradiated from the ITO side to etch organic function layers and the second electrode. Etching rates of certain materials may be enhanced if a single or a plurality of appropriate reactive gases are introduced together with the laser beam. The shape and size of a laser beam spot may be adjusted as necessary. In addition, a plurality of sub-pixels may be etched simultaneously with the use of a properly designed etching mask, as shown in Fig. 10. Irradiating a large area at a time would require a laser system with a large beam spot and a high power.

The method of fabricating an organic EL display panel has the following advantages.

Primarily, the production yield is significantly raised because a simple and fast laser processing method is employed and also because a shadow mask, difficult to make and even more tricky to accurately align with respect to a substrate, is not used for the fabrication. Furthermore, the long-term stability is much improved by minimizing the exposure of active EL elements to detrimental solvents and moisture.

It will be apparent to those skilled in the art that various modifications and variations can be made in the method of fabricating an organic EL display panel of the present invention without departing from the scope of the invention. Thus, it is intended that the present invention cover the modifications and variations of this invention provided they come within the scope of the appended claims.

## Claims

1. A method of fabricating an organic electroluminescent (EL) display panel, comprising:
forming a first electrode layer (102) on a transparent substrate (101); and
forming an insulating layer (104) having an insulating surface on the first electrode layer, **characterised in that** the method further comprises the steps of:
selectively removing portions of the insulating layer at predetermined first regions using at least one laser beam to expose a first set of sub-pixel electrodes;
forming a set of organic function layers (105a) on the first set of sub-pixel electrodes and on remaining portions of the insulating surface, said organic function layers comprising at least one organic EL medium layer; and
forming a set of second electrode layers (106a) on the organic function layers to form a second set of sub-pixel electrodes, wherein the first set of sub-pixel electrodes, the portions of the organic function layers electrically communicating with the first set of sub-pixel electrodes and the second set of sub-pixel electrodes, and the second set of sub-pixel electrodes form a first set of sub-pixels and wherein the remaining portions of the insulating layer (104) following selective removal of the predetermined first regions separate a sub-pixel from other sub-pixels.

2. The method of claim 1, further comprising:
forming a second set of sub-pixels by selectively removing portions of the insulating layer, and portions of the organic function layer and second electrode previously deposited on said insulating layer, at predetermined second regions using at least one laser beam;
forming a second organic function layer (105b) on the predetermined second regions and on remaining portions of the insulating layer, said second organic function layer comprising at least one organic EL medium layer; and
forming a third electrode layer (106b) on the second organic function layer, wherein the first electrode layer (102), the portions of second organic function layer electrically communicating with the first electrode layer and the third electrode layer, and the third electrode layer form a second set of sub-pixels.

3. The method of claim 1 or 2, further comprising forming a buffer layer (103) between the insulating layer and the first electrode layer.

4. The method of any preceding claim, wherein the buffer layer (103) is formed of an electrically insulating inorganic or electrically insulating organic material.

5. The method of any preceding claim, wherein the insulating layer (104) is formed of at least one polymeric material.

6. The method of any preceding claim, wherein the insulating layer (104) is formed to a thickness of 0.1 µm - 100 µm.

7. The method of any preceding claim, wherein selectively removing portions of the insulating layer (104) is conducted in a vacuum, or in a dry atmosphere, or in an inert atmosphere.

8. The method of any preceding claim, further comprising forming a protection layer (107) over said organic EL display panel.

9. The method of claim 8, wherein the protection layer (107) comprises at least one moisture absorbing material.

10. The method of claim 1, further comprising:
forming a protection layer (107a) on at least the second set of sub-pixel electrodes, wherein the first set of sub-pixel electrodes, the organic function layers, the second set of sub-pixel electrodes and the protection layer form a first set of sub-pixels wherein individual sub-pixels are defined through laser removal of the insulating layer without removal of portions of the first electrode material, second electrode material, and organic function layer materials which are used to form the set of sub-pixels.

11. The method of claim 10, further comprising:
forming a second set of sub-pixels by selectively removing portions of the insulating layer (104) and portions of the organic function layer, second electrode and protection layer previously deposited on said insulating layer, at predetermined second regions using at least one laser beam;
forming a second organic function layer (105b) on the predetermined second regions and on remaining portions, said second organic function layer comprising at least one organic EL medium layer; and
forming a third electrode layer (106b) on the second organic function layer, wherein the first electrode layer, the portions of second organic function layer electrically communicating with the first electrode layer and the third electrode layer, and the third electrode layer form a second set of sub-pixels.

12. The method of claim 10 or 11, wherein the protection layer (107a) comprises at least one moisture absorbing material.

13. The method of any of claims 10 to 12, further comprising forming a buffer layer (103) between the insulating layer and the first electrode layer.

14. The method of claim 11, further comprising forming an additional protection layer (107d) over said organic EL display panel.

15. The method of claim 14, wherein the additional protection layer (107d) comprises at least one moisture absorbing material.

16. The method of claim 2, further comprising:
cutting, into two parts, the first and second organic function layers and the second and third electrode layers formed on the insulating layer between the first and second sub-pixels.

## Revendications

1. Un procédé de fabrication d'un panneau d'affichage électroluminescent (EL) organique, comprenant les étapes de :
- former une première couche d'électrode (102) sur un substrat transparent (101); et
- former une couche isolante (104) possédant une surface isolante sur la première couche d'électrode, **caractérisé en ce que** le procédé comprend en outre les étapes consistant à :
- enlever de manière sélective des parties de la couche isolante au niveau de premières zones prédéterminées en utilisant au moins un faisceau laser pour exposer une première série d'électrodes de sous-pixel ;
- former une série de couches de fonction organiques (105a) sur la première série d'électrodes de sous-pixel et sur les parties restantes de la surface isolante, lesdites couches de fonction organiques comprenant au moins une couche intermédiaire EL organique ; et
- former une série de deuxièmes couches d'électrode (106a) sur les couches de fonction organiques afin de former une seconde série d'électrodes de sous-pixel, dans laquelle la première série d'électrodes de sous-pixel, les parties des couches de fonction organiques communiquant électriquement avec la première série d'électrodes de sous-pixel et la seconde série d'électrodes de sous-pixel, et la seconde série d'électrodes de sous-pixel forment une première série de sous-pixels et dans laquelle les parties restantes de la couche isolante (104) suivant l'enlèvement sélectif des premières zones prédéterminées séparent un sous-pixel des autres sous-pixels.

2. Le procédé selon la revendication 1, comprenant en outre les étapes de:
- former une seconde série de sous-pixels en enlevant de manière sélective des parties de la couche isolante, et des parties de la couche de fonction organique et une seconde électrode déposée précédemment sur ladite couche isolante, au niveau de secondes zones prédéterminées en utilisant au moins un faisceau laser ;
- former une seconde couche de fonction organique (105b) sur les secondes zones prédéterminées et sur les parties restantes de la couche isolante, ladite seconde couche de fonction organique comprenant au moins une couche intermédiaire EL organique ; et
- former une troisième couche d'électrode (106b) sur la seconde couche de fonction organique, dans laquelle la première couche d'électrode (102), les parties de la seconde couche de fonction organique communiquant électriquement avec la première couche d'électrode et la troisième couche d'électrode, et la troisième couche d'électrode forment une seconde série de sous-pixels.

3. Le procédé selon la revendication 1 ou 2, comprenant en outre la formation d'une couche tampon (103) entre la couche isolante et la première couche d'électrode.

4. Le procédé selon l'une quelconque des revendications précédentes, dans lequel la couche tampon (103) est formée d'un matériau inorganique électriquement isolant ou d'un matériau organique électriquement isolant.

5. Le procédé selon l'une quelconque des revendications précédentes, dans lequel la couche isolante (104) est formée d'au moins un matériau polymérisé.

6. Le procédé selon l'une quelconque des revendications précédentes, dans lequel la couche isolante (104) est formée avec une épaisseur de 0,1 µm à 100 µm.

7. Le procédé selon l'une quelconque des revendications précédentes, dans lequel l'enlèvement sélectif des parties de la couche isolante (104) est réalisé dans une atmosphère sous vide ou sèche, ou dans une atmosphère inerte.

8. Le procédé selon l'une quelconque des revendications précédentes, comprenant en outre la formation d'une couche de protection (107) sur ledit panneau d'affichage EL organique.

9. Le procédé selon la revendication 8, dans lequel la couche de protection (107) comprend au moins un matériau absorbant l'humidité.

10. Le procédé selon la revendication 1, comprenant en outre l'étape de :
- former une couche de protection (107a) sur au moins la seconde série d'électrodes de sous-pixel, dans laquelle la première série d'électrodes de sous-pixel, les couches de fonction organiques, la seconde série d'électrodes de sous-pixel et la couche de protection forment une première série de sous-pixels dans laquelle des sous-pixels individuels sont définis par un enlèvement au laser de la couche isolante sans enlever les parties du premier matériau d'électrode, du second matériau d'électrode, et des matériaux de couche de fonction organique qui sont utilisés pour former la série de sous-pixels.

11. Le procédé selon la revendication 10, comprenant en outre les étapes de :
- former une seconde série de sous-pixels en enlevant de manière sélective des parties de la couche isolante (104) et des parties de la couche de fonction organique, de la deuxième couche d'électrode et de protection déposée précédemment sur ladite couche isolante, au niveau de secondes zones prédéterminées en utilisant au moins un faisceau laser ;
- former une seconde couche de fonction organique (105b) sur les secondes zones prédéterminées et sur les parties restantes, ladite seconde couche de fonction organique comprenant au moins une couche intermédiaire EL organique ; et
- former une troisième couche d'électrode (106b) sur la seconde couche de fonction organique, dans laquelle la première couche d'électrode, les parties de la seconde couche de fonction organique communiquant électriquement avec la première couche d'électrode et la troisième couche d'électrode, et la troisième couche d'électrode forment une seconde série de sous-pixels.

12. Le procédé selon la revendication 10 ou 11, dans lequel la couche de protection (107a) comprend au moins un matériau absorbant l'humidité.

13. Le procédé selon l'une quelconque des revendications 10 à 12, comprenant en outre la formation d'une couche tampon (103) entre la couche isolante et la première couche d'électrode.

14. Le procédé selon la revendication 11, comprenant en outre la formation d'une couche de protection supplémentaire (107d) sur ledit panneau d'affichage EL organique.

15. Le procédé selon la revendication 14, dans lequel la couche de protection supplémentaire (107d) comprend au moins un matériau absorbant l'humidité.

16. Le procédé selon la revendication 2, comprenant en outre l'étape de :
- découper, en deux parties, les première et seconde couches de fonction organiques et les deuxième et troisième couches d'électrode formées sur la couche isolante entre les premier et second sous-pixels.

## Patentansprüche

1. Verfahren zur Herstellung einer organischen elektrolumineszenten (EL) Anzeigetafel, umfassend:
Bilden einer ersten Elektrodenschicht (102) auf einem transparenten Substrat (101); und
Bilden einer Isolierschicht (104) mit einer isolierenden Oberfläche auf der ersten Elektrodenschicht,
**dadurch gekennzeichnet, dass** das Verfahren des Weiteren die folgenden Schritte umfasst:
Selektives Entfernen von Teilen der Isolierschicht an vorher bestimmten ersten Bereichen unter Verwendung mindestens eines Laserstrahls zum Freilegen eines ersten Satzes an Subpixel-Elektroden;
Bilden eines Satzes an organischen Funktionsschichten (105a) auf dem ersten Satz an Subpixel-Elektroden und auf übrigen Teilen der isolierenden Oberfläche, wobei die organischen Funktionsschichten mindestens eine organische EL-Medium-Schicht umfassen; und
Bilden eines Satzes von zweiten Elektrodenschichten (106a) auf den organischen Funktionsschichten unter Bildung eines zweiten Satzes an Subpixel-Elektroden, wobei der erste Satz an Subpixel-Elektroden, die Teile der organischen Funktionsschichten, die mit dem ersten Satz an Subpixel-Elektroden und dem zweiten Satz an Subpixel-Elektroden elektrisch kommunizieren, und der zweite Satz an Subpixel-Elektroden einen ersten Satz an Subpixel bilden und wobei die übrigen Teile der Isolierschicht (104) nach der selektiven Entfernung der vorher bestimmten ersten Bereiche ein Subpixel von anderen Subpixel abtrennt.

2. Verfahren gemäß Anspruch 1, des Weiteren umfassend:
Bilden eines zweiten Satzes an Subpixel durch selektives Entfernen von Teilen der Isolierschicht und Teilen der organischen Funktionsschicht und der zweiten Elektrode, die vorher auf der Isolierschicht abgeschieden wurde, an vorher bestimmten zweiten Bereichen unter Verwendung mindestens eines Laserstrahls;
Bilden einer zweiten organischen Funktionsschicht (105b) auf den vorher bestimmten zweiten Bereichen und auf übrigen Teilen der Isolierschicht, wobei die zweite organische Funktionsschicht mindestens eine organische EL-Medium-Schicht umfasst; und
Bilden einer dritten Elektrodenschicht (106b) auf der zweiten organischen Funktionsschicht, wobei die erste Elektrodenschicht (102), die Teile der zweiten organischen Funktionsschicht, die mit der ersten Elektrodenschicht und der dritten Elektrodenschicht elektrisch kommunizieren, und die dritte Elektrodenschicht einen zweiten Satz an Subpixel bilden.

3. Verfahren gemäß Anspruch 1 oder 2, des Weiteren umfassend das Bilden einer Pufferschicht (103) zwischen der Isolierschicht und der ersten Elektrcdenschicht.

4. Verfahren gemäß einem der vorangehenden Ansprüche, wobei die Pufferschicht (103) aus einem elektrisch isolierenden anorganischen oder elektrisch isolierenden organischen Material gebildet ist.

5. Verfahren gemäß einem der vorangehenden Ansprüche, wobei die Isolierschicht (104) aus mindestens einem Polymermaterial gebildet ist.

6. Verfahren gemäß einem der vorangehenden Ansprüche, wobei die Isolierschicht (104) mit einer Dicke von 0,1 µm - 100 µm gebildet ist.

7. Verfahren gemäß einem der vorangehenden Ansprüche, wobei das selektive Entfernen von Teilen der Isolierschicht (104) in Vakuum oder in trockener Atmosphäre oder in inerter Atmosphäre durchgeführt wird.

8. Verfahren gemäß einem der vorangehenden Ansprüche, des Weiteren umfassend das Bilden einer Schutzschicht (107) auf der organischen EL-Anzeigetafel.

9. Verfahren gemäß Anspruch 8, wobei die Schutzschicht (107) mindestens ein feuchtigkeitsabsorbierendes Material umfasst.

10. Verfahren gemäß Anspruch 1, des Weiteren umfassend:
Bilden einer Schutzschicht (107a) auf mindestens dem zweiten Satz an Subpixel-Elektroden, wobei der erste Satz an Subpixel-Elektroden, die organischen Funktionsschichten, der zweite Satz an Subpixel-Elektroden und die Schutzschicht einen ersten Satz an Subpixel bilden, wobei einzelne Subpixel durch Laserentfernung der Isolierschicht ohne Entfernung von Teilen des ersten Elektrodenmaterials, des zweiten Elektrodenmaterials und der Materialien der organischen Funktionsschicht, die zum Bilden des Satzes an Subpixel verwendet werden, definiert sind.

11. Verfahren gemäß Anspruch 10, des Weiteren umfassend:
Bilden eines zweiten Satzes an Subpixel durch selektives Entfernen von Teilen der Isolierschicht (104) und Teilen der organischen Funktionsschicht, der zweiten Elektrode und der Schutzschicht, die vorher auf der Isolierschicht abgeschieden wurde, in vorher bestimmten zweiten Bereichen unter Verwendung mindestens eines Laserstrahls;
Bilden einer zweiten organischen Funktionsschicht (105b) auf den vorher bestimmten zweiten Bereichen und auf übrigen Teilen, wobei die zweite organische Funktionsschicht mindestens eine organische EL-Medium-Schicht umfasst; und
Bilden einer dritten Elektrodenschicht (106b) auf der zweiten organischen Funktionsschicht, wobei die erste Elektrodenschicht, die Teile der zweiten organischen Funktionsschicht, die mit der ersten Elektrodenschicht und der dritten Elektrodenschicht elektrisch kommunizieren, und die dritte Elektrodenschicht einen zweiten Satz an Subpixel bilden.

12. Verfahren gemäß Anspruch 10 oder 11, wobei die Schutzschicht (107a) mindestens ein feuchtigkeitsabsorbierendes Material umfasst.

13. Verfahren gemäß einem der Ansprüche 10 bis 12, des Weiteren umfassend eine Pufferschicht (103) zwischen der Isolierschicht und der ersten Elektrodenschicht.

14. Verfahren gemäß Anspruch 11, des Weiteren umfassend das Bilden einer zusätzlichen Schutzschicht (107d) auf der EL-Anzeigetafel.

15. Verfahren gemäß Anspruch 14, wobei die zusätzliche Schutzschicht (107d) mindestens ein feuchtigkeitsabsorbierendes Material umfasst.

16. Verfahren gemäß Anspruch 2, des Weiteren umfassend:
Schneiden der ersten und zweiten Funktionsschicht und der zweiten und dritten Elektrodenschicht, die auf der Isolierschicht zwischen den ersten und zweiten Subpixel gebildet sind, in zwei Teile.
